# FASCICULE DE BREVET EUROPEEN

(11) **EP 3 863 074 B1**
(45) Date de publication et mention de la délivrance du brevet: **17.08.2022**
(21) Numéro de dépôt: 21154716.1
(22) Date de dépôt: 02.02.2021
(51) Int. Cl.: H01L 27/24, H01L 45/00

(54) **CELLULE MÉMOIRE À CHANGEMENT DE PHASE**
SPEICHERZELLE MIT PHASENUMWANDLUNG
PHASE-CHANGING MEMORY CELL

(30) Priorité: 06.02.2020 FR 2001192
(43) Date de publication de la demande: 11.08.2021
(73) Titulaire: Commissariat à l'Energie Atomique et aux Energies Alternatives, 75015 Paris (FR)
(72) Inventeur: CAPPELLETTI, Paolo Giuseppe, 20030 SEVESO (MI) (IT); NAVARRO, Gabriele, 38054 GRENOBLE CEDEX 9 (FR)
(74) Mandataire: Cabinet Beaumont

(56) Documents cités:
- US-A1- 2006 113 520
- US-A1- 2007 200 108
- US-A1- 2008 050 892

## Description

### Domaine technique

La présente description concerne de façon générale des dispositifs mémoire, et plus particulièrement des cellules mémoire à changement de phase.

### Technique antérieure

Les matériaux à changement de phase sont des matériaux qui peuvent commuter sous l'effet de la chaleur, entre une phase cristalline et une phase amorphe. Puisque la résistance électrique d'un matériau amorphe est notablement supérieure à la résistance électrique d'une phase cristalline du même matériau, un tel phénomène est utilisé pour définir deux états mémoire, par exemple 0 et 1, différenciés par la résistance mesurée à travers le matériau à changement de phase. Les matériaux à changement de phase les plus courants utilisés pour fabriquer des mémoires sont des alliages constitués de germanium, d'antimoine et de tellure. Exemples de l'art antérieur se trouve dans les brevets US2008/050892, US2006/113520 et US2007/200108.

### Résumé de l'invention

Il existe un besoin d'améliorer les cellules mémoire à changement de phase existantes afin d'obtenir de manière fiable un nombre d'états mémoire supérieur à deux.

Il existe un besoin d'améliorer les cellules mémoire à changement de phase existantes afin qu'elles soient moins affectées par des problèmes de défauts d'alignement.

Un mode de réalisation pallie tout ou partie des inconvénients des cellules mémoire à changement de phase connues.

Un mode de réalisation prévoit une cellule mémoire à changement de phase, comprenant : un élément chauffant ; un empilement d'au moins une couche de germanium ou d'une couche de germanium dopé à l'azote et d'au moins une couche d'un premier alliage constitué de germanium, d'antimoine et de tellure ; et une couche résistive, située entre l'élément chauffant et l'empilement.

Selon un mode de réalisation, des parois latérales de l'empilement et de la couche résistive sont entourées d'une région isolante.

Selon un mode de réalisation, la couche résistive s'étend en dessous de la totalité de la couche inférieure de l'empilement.

Selon un mode de réalisation, la couche résistive est en contact avec l'élément chauffant et la couche inférieure de l'empilement.

Selon un mode de réalisation, l'empilement comprend une deuxième région en un deuxième alliage constitué de germanium, d'antimoine et de tellure, la deuxième région s'étendant à partir de la couche résistive et à travers la couche de germanium ou de germanium dopé à l'azote, le deuxième alliage ayant une concentration en germanium supérieure à celle du premier alliage.

Selon un mode de réalisation, une couche conductrice repose sur la couche supérieure de l'empilement.

Selon un mode de réalisation, il n'y a aucune partie de la couche de germanium entre la partie supérieure de la région et la couche conductrice.

Selon un mode de réalisation : un premier état mémoire est défini par le fait que la région est entièrement dans un état cristallin ; un deuxième état mémoire est défini par le fait qu'il comporte une région amorphe recouvrant totalement une surface supérieure de la couche résistive ; et au moins un état mémoire intermédiaire est défini par le fait que la région amorphe recouvre partiellement la surface supérieure de la couche résistive.

Un autre mode de réalisation prévoit un procédé de fabrication de la cellule de l'une quelconque des revendications 1 à 8, comprenant une étape dans laquelle une partie de l'empilement est chauffée jusqu'à une température suffisante pour que les parties des couches de germanium ou de germanium dopé à l'azote et du premier alliage situées dans cette partie forment un deuxième alliage constitué de germanium, d'antimoine et de tellure, le deuxième alliage ayant une concentration en germanium supérieure à celle du premier alliage.

Selon un mode de réalisation, le procédé comprend une étape de chauffage de la région afin d'atteindre l'un d'au moins trois états mémoire.

Selon un mode de réalisation, la région est chauffée par l'intermédiaire de l'élément chauffant et de la couche résistive.

Selon un mode de réalisation, la résistance électrique de la cellule augmente de façon monotone en augmentant une partie de la région amorphe qui recouvre la surface supérieure de la couche résistive.

Un autre mode de réalisation prévoit un dispositif mémoire comprenant au moins une cellule mémoire telle que décrite.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective simplifiée d'un exemple de dispositif mémoire à changement de phase ;
la figure 2 représente deux vues en coupe simplifiées (A) et (B) d'un mode de réalisation d'une cellule mémoire à changement de phase résultant d'une étape de fabrication ;
la figure 3 représente deux vues en coupe simplifiées (A) et (B) d'un mode de réalisation d'une cellule mémoire à changement de phase résultant d'une étape de fabrication à la suite de l'étape de la figure 2 ;
la figure 4 représente trois vues en coupe simplifiées (A), (B) et (C) de diverses étapes d'un procédé d'écriture dans une cellule mémoire à changement de phase ;

la figure 5 est un diagramme illustrant un exemple de variations de la résistance correspondant à plusieurs états de la cellule mémoire à changement de phase ; et

la figure 6 représente schématiquement un mode de réalisation d'une mémoire.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments couplés entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement" et "de l'ordre de" signifient à 10 % près, de préférence à 5 % près.

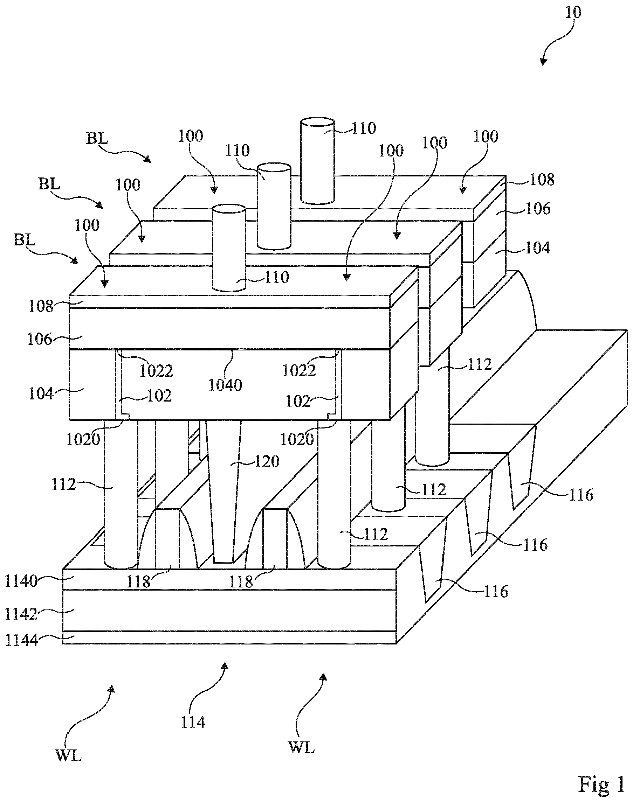

La figure 1 est une vue en perspective simplifiée d'un exemple de dispositif mémoire à changement de phase 10 comprenant une pluralité de cellules mémoire 100.

Les cellules mémoire à changement de phase (PCM), telles que les cellules mémoire 100 représentées en figure 1, sont typiquement incorporées dans des dispositifs à mémoire non volatile (NVM) comme les mémoires à lecture seule programmables et effaçables électriquement (EEPROM). La programmation de chaque cellule mémoire dans de tels dispositifs mémoire est habituellement réalisée lors de la fabrication des dispositifs mémoire et peut ultérieurement être modifiée plusieurs fois, en particulier pendant leur utilisation.

Comme cela est représenté en figure 1, les cellules mémoire 100 du dispositif mémoire 10 sont agencées selon un motif en forme de grille ou de matrice. En d'autres termes, le dispositif mémoire 10 est composé d'une matrice de cellules mémoire 100. Chaque cellule mémoire 100 est disposée à l'intersection d'une rangée et d'une colonne de la matrice. En figure 1, seules trois colonnes BL et deux rangées WL sont représentées.

Les colonnes BL, qui sont parallèles entre elles et parallèles au plan de la figure 1, seront encore appelées "lignes de bit" (BL). Les rangées, qui sont parallèles entre elles et perpendiculaires aux lignes de bit, seront encore appelées "lignes de mot" (WL).

Chaque cellule mémoire à changement de phase 100 du dispositif mémoire 10 comprend un élément chauffant 102 ou élément résistif. Dans l'exemple de la figure 1, l'élément chauffant 102 a une section transversale en forme de L et par conséquent comprend une partie horizontale et une partie verticale.

L'élément chauffant 102 est en général entouré d'une couche isolante ou diélectrique 104, qui est par exemple composée de nitrure et/ou d'oxyde, par exemple d'oxyde de silicium ou de nitrure de silicium. L'épaisseur de cette couche isolante 104 est telle que la surface supérieure 1022 de la partie verticale de l'élément chauffant 102 est coplanaire avec la surface supérieure 1040 de la couche isolante 104.

Chaque cellule mémoire 100 comprend en outre une couche 106. Cette couche 106 est en un matériau à changement de phase. La couche 106 est formée et repose à la fois sur la surface supérieure 1040 de la couche isolante 104 et sur la surface supérieure 1022 de la partie verticale de l'élément chauffant 102.

Une couche métallique conductrice 108 repose sur le dessus de la couche 106. Cette couche conductrice 108 forme typiquement une électrode de la cellule mémoire 100.

Dans l'exemple de la figure 1, des cellules mémoire 100 appartenant à une ligne de bit donnée partagent la même couche isolante 104, la même couche 106 et la même couche conductrice 108. Dans le dispositif mémoire 10, les couches 104, 106 et 108 s'étendent ainsi latéralement suivant la direction BL (vers la gauche et vers la droite, en figure 1). Toutes les cellules mémoire 100 d'une ligne de bit donnée partagent par conséquent une électrode commune 108. Des vias conducteurs 110 sont prévus pour connecter chaque électrode 108 à un niveau de métallisation situé au-dessus des cellules mémoire 100 du dispositif mémoire 10.

L'élément chauffant 102 de chaque cellule mémoire 100 est typiquement connecté, par son pied 1020 (c'est-à-dire une surface inférieure de sa partie horizontale), à un contact inférieur 112 ou pilier. Ce contact inférieur 112 s'étend verticalement et est connecté à un substrat 114.

Dans l'exemple de la figure 1, le substrat 114 a une structure multicouche, qui est composée de trois couches :
une première couche 1140 constituée d'un film mince de silicium, auquel les contacts inférieurs 112 sont connectés ;
une deuxième couche 1142 constituée d'oxyde mince enterré ; et
une troisième couche 1144 constituée d'une tranche de silicium épais.

Le substrat 114 présente aussi des isolations par tranchées peu profondes (STI) 116 entre les parties du substrat en contact avec les contacts inférieurs 112 appartenant à des lignes de bit adjacentes. Ces isolations par tranchées peu profondes 116 empêchent la fuite de courant électrique entre des lignes de bit différentes du dispositif mémoire 10. Dans le dispositif mémoire 10, les isolations par tranchées peu profondes 116 s'étendent ainsi latéralement suivant la direction BL (vers la gauche et vers la droite, en figure 1).

Le contact inférieur 112 de chaque cellule mémoire 100 est connecté à une borne d'un élément de sélection. L'élément de sélection, souvent appelé sélecteur ou dispositif d'accès, assure la capacité à adresser/sélectionner individuellement chaque cellule mémoire 100 du dispositif mémoire 10. Dans l'exemple de la figure 1, le sélecteur d'une cellule mémoire 100 est un transistor dont la grille 118 reçoit une tension de polarisation. En fonction de sa valeur, cette tension de polarisation permet l'activation ou la désactivation d'un courant entre l'électrode 108 et une région conductrice 120 connectée à l'autre borne de l'élément de sélection et à un potentiel de référence commun, typiquement un potentiel de masse.

Dans l'exemple de la figure 1, les transistors de sélection des cellules mémoire 100 appartenant à une ligne de mot ou rangée donnée partagent la même grille 118. Dans le dispositif mémoire 10, les grilles 118 et la région 120 s'étendent ainsi longitudinalement suivant la direction WL (vers l'avant et vers l'arrière, en figure 1). Tous les transistors de sélection des cellules mémoire 100 d'une ligne de mot donnée sont par conséquent connectés à une même grille 118.

Les couches conductrices 108 et les grilles 118 forment par conséquent toutes deux un motif en forme de matrice ou de grille, dans lequel chaque intersection est à peu près alignée verticalement avec une cellule mémoire 100.

Il se trouve que la couche 106 est de manière native, c'est-à-dire après la fabrication de la cellule mémoire 100 et avant le début des opérations d'écriture/programmation, soit dans un état/phase entièrement cristallin soit dans un état/phase partiellement cristallin. Il est usuel de réaliser une première opération électrique pour mettre la couche 106 de toutes les cellules mémoire dans un état/phase entièrement cristallin. On supposera, par exemple, que cette phase cristalline correspond à la valeur logique 1. Dans la mémoire à changement de phase 10 constituée d'une pluralité de cellules mémoire 100, un état initial correspond ainsi à un état où toutes les cellules mémoire 100 ont la même valeur 1. La mémorisation de données dans la mémoire à changement de phase 10 est alors réalisée en écrivant/programmant certaines de ses cellules mémoire 100, tandis que d'autres cellules de ses cellules mémoire 100 sont laissées dans leur état (c'est-à-dire dans un état cristallin).

Pour écrire dans, ou programmer, une cellule mémoire à changement de phase 100 donnée de la mémoire 10, cette cellule mémoire 100 est d'abord sélectionnée en appliquant une polarisation en tension appropriée à la grille associée 118. On fait passer ensuite un courant électrique à travers la couche 106 en appliquant une impulsion de potentiel électrique appropriée entre l'électrode 108 associée et la région de masse commune 120. Le potentiel électrique ou l'intensité de ce courant électrique est soigneusement ajusté pour augmenter suffisamment la température de l'élément chauffant 102 pour chauffer, par effet Joule, une région de la couche 106 en contact avec l'extrémité supérieure 1022 de l'élément chauffant 102. Cela provoque la fusion d'au moins une partie du matériau à changement de phase, dont la couche 106 est constituée. Si le front descendant de l'impulsion de potentiel est abrupte, à la fin de l'impulsion, le flux de courant électrique se termine rapidement et, en conséquence, la température locale diminue rapidement, ce qui réalise une trempe de la structure vitreuse de la partie fondue du matériau à changement de phase. En résultat, l'impulsion électrique a transformé une partie du matériau à changement de phase d'une phase cristalline faiblement résistive en un état amorphe fortement résistif. On supposera par exemple que cet état amorphe correspond à la valeur logique 0.

Pour lire une cellule mémoire à changement de phase 100 donnée, cette cellule mémoire 100 est d'abord sélectionnée en appliquant une polarisation en tension appropriée à la grille 118 associée. On fait ensuite passer un courant, dont la valeur est suffisamment faible pour éviter tout changement de phase involontaire, à travers la cellule 100 en appliquant un potentiel électrique approprié entre l'électrode 108 associée et la région de masse commune 120. Une résistance électrique, entre l'électrode 108 et l'élément chauffant 102, peut alors être mesurée. Cette résistance électrique reflète la valeur, 0 ou 1, qui était précédemment mémorisée dans la cellule mémoire 100.

Un inconvénient du dispositif mémoire 10 décrit en figure 1 provient du fait que la couche 106 n'appartient pas uniquement à une seule cellule mémoire 100, mais est aussi partagée par toutes les cellules mémoire 100 d'une même ligne de bit. Cela peut conduire à des problèmes pendant la programmation d'une cellule mémoire 100 donnée, en raison de la diffusion thermique latérale qui peut perturber l'état amorphe de cellules adjacentes de la même ligne de bit. Cela peut aussi conduire à des problèmes pendant la lecture d'une cellule mémoire 100 donnée, puisque des chemins alternatifs de passage de courant sont facilement assurés par des cellules mémoire 100 adjacentes de la même ligne de bit. Ces problèmes sont souvent appelés phénomènes de "diaphonie" entre cellules mémoire adjacentes.

Un autre inconvénient de la cellule mémoire 100 représentée en figure 1 est que seulement deux états mémoire (correspondant typiquement à un état complètement cristallin et un état complètement amorphe) peuvent être obtenus facilement grâce à une telle cellule. En d'autres termes, un seul bit d'information peut être mémorisé facilement dans une cellule mémoire 100. Cela est dû au fait que des états intermédiaires possibles ne sont pas stables puisqu'ils sont soumis à un phénomène de dérive de résistance, qui conduit typiquement à une augmentation de la résistance dans le temps.

Selon les modes de réalisation décrits ci-après, la conception de la cellule mémoire 100 est modifiée afin de pallier au moins en partie les inconvénients susmentionnés des cellules mémoire à changement de phase connues.

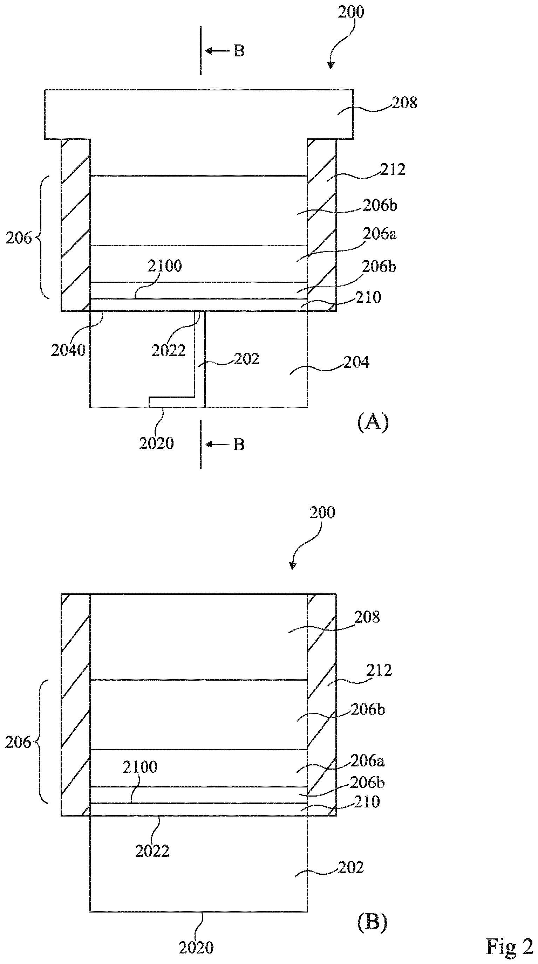

La figure 2 représente deux vues en coupe simplifiées (A) et (B) d'un mode de réalisation d'une cellule mémoire à changement de phase 200 résultant d'une étape de fabrication.

La vue (B) est une vue en coupe, selon un plan de coupe B-B, de la cellule mémoire 200 représentée en vue (A).

La cellule mémoire à changement de phase 200 comprend un élément chauffant ou élément résistif 202. L'élément chauffant 202 a, comme cela est représenté en vue (A), une section transversale en forme de L. Cet élément chauffant 202 est connecté, par son pied 2020 (c'est-à-dire une surface inférieure de sa partie horizontale), à un élément de sélection (non représenté en figure 2), par exemple un transistor. L'élément de sélection donne la possibilité d'adresser/sélectionner individuellement chaque cellule mémoire 200 dans un dispositif mémoire comprenant une matrice de cellules mémoire 200.

L'élément chauffant 202 est entouré d'une couche isolante 204. L'épaisseur de cette couche isolante 204 est telle que la surface supérieure 2022 de la partie verticale de l'élément chauffant 202 est coplanaire avec la surface supérieure 2040 de la couche isolante 204. L'élément de sélection (non représenté en figure 2) est situé en dessous de la couche isolante 204 et est connecté électriquement au pied 2020 de l'élément chauffant 202.

La cellule mémoire 200 comprend un empilement 206 de couches 206a en germanium ou en germanium dopé à l'azote et de couches 206b en un premier alliage de germanium, d'antimoine et de tellure. Les couches de l'empilement 206 sont alternativement des couches 206a et des couches 206b.

Dans le mode de réalisation de la figure 2, l'empilement 206 comprend une couche de germanium 206a et deux couches 206b du premier alliage. La couche inférieure de l'empilement 206 est, dans cet exemple, l'une des couches 206b. La couche 206a est par conséquent située entre les deux couches 206b.

Le premier alliage est un alliage stable, c'est-à-dire un alliage dans lequel les proportions des divers composants sont proches d'une proportion stœchiométrique. Le premier alliage est par exemple Ge₂Sb₂Te₅, Ge₄Sb₄Te₇ ou un alliage constitué de germanium, d'antimoine et de tellure avec des pourcentages atomiques proches de, et par exemple sensiblement égaux aux pourcentages atomiques de Ge₂Sb₂Te₅ ou Ge₄Sb₄Te₇. Le premier alliage des couches 206b est de préférence dans une phase cristalline. Les couches 206a sont par exemple en germanium non dopé ou en germanium dopé avec des atomes d'azote. Dans le cas où les couches 206a sont en germanium dopé avec des atomes d'azote, le contenu en azote est de préférence inférieur à 35 % du compte d'atomes. Le matériau de la couche 206a est par exemple dans une phase amorphe.

Les couches de l'empilement 206 ont par exemple une épaisseur supérieure à environ 4 nm, par exemple comprise entre 4 et 30 nm. Les couches 206a et 206b peuvent être d'épaisseurs différentes.

Dans certains modes de réalisation, les diverses couches 206b sont en des alliages différents de germanium, d'antimoine et de tellure choisis parmi les exemples donnés précédemment pour le premier alliage. Par exemple, l'empilement 206 peut comprendre une couche 206a en germanium située entre une couche 206b en Ge₂Sb₂Te₅ et une couche 206b en Ge₄Sb₄Te₇. Ces différents alliages seront néanmoins appelés premier alliage dans la description qui suit.

Plus généralement, l'empilement 206 comprend au moins une couche de germanium 206a et au moins une couche 206b faite du premier alliage. La couche 206b recouvre de préférence la couche 206a. De préférence, l'empilement 206 comprend une couche 206a située entre deux couches 206b faites du premier alliage. L'empilement 206 peut comprendre un nombre quelconque de couches, supérieur à deux. Le nombre de couches peut être pair ou impair. En outre, la couche inférieure de l'empilement 206 peut être une couche de germanium 206a ou une couche 206b faite du premier alliage.

Une couche conductrice 208 repose sur et est en contact avec l'empilement 206, plus particulièrement avec la couche supérieure de l'empilement (l'une des couches 206b, dans l'exemple de la figure 2). Cette couche conductrice 208 forme typiquement une électrode (à connecter à la ligne de bit) de la cellule mémoire 200, alors que l'élément chauffant 202 forme une autre électrode (à connecter à la ligne de mot) de la cellule mémoire 200. Les deux électrodes sont aussi appelées ici électrode "supérieure" 208 et électrode "inférieure" 202, bien qu'aucune limitation ne soit implicite quant à l'orientation de la cellule mémoire 200 en fonctionnement.

Dans l'exemple de la vue (A), la partie supérieure de l'électrode supérieure 208 s'étend horizontalement suivant une direction orthogonale au plan de coupe BB. L'élément chauffant 202 est de préférence centré par rapport à la cellule mémoire 200.

Selon un mode de réalisation préféré, une couche résistive 210 est intercalée entre la couche isolante 204 et l'empilement 206. En d'autres termes :
la couche résistive 210 est formée et repose à la fois sur la surface supérieure 2040 de la couche isolante 204 et sur la surface supérieure 2022 de la partie verticale de l'élément chauffant 202, la couche 210 étant en contact électrique avec l'élément chauffant 202 ; et
l'empilement 206 est formé et repose sur la surface supérieure 2100 de la couche résistive 210.

De préférence, la couche résistive 210 s'étend en dessous de la totalité de la couche inférieure de l'empilement 206.

La couche résistive 210 est par exemple en un métal réfractaire et/ou un nitrure de métal réfractaire, comme le nitrure de titane (TiN), le tantale (Ta), le nitrure de tantale (TaN) ou le tungstène (W).

Les parois latérales de la cellule mémoire 200 sont entourées d'une région isolante 212. Toutes les quatre faces latérales de l'empilement 206 et de la couche résistive 210 sont, comme cela est représenté dans les vues (A) et (B), totalement enfermées/enveloppées par cette région isolante 212, bien que seulement une partie de la couche conductrice 208 soit flanquée de la région isolante 212. Dans un dispositif mémoire (non représenté en figure 2) constitué d'une matrice de cellules mémoire 200, cela permet à l'électrode supérieure 208 d'être connectée à l'empilement 206 d'autres cellules mémoire 200 d'une même ligne de bit.

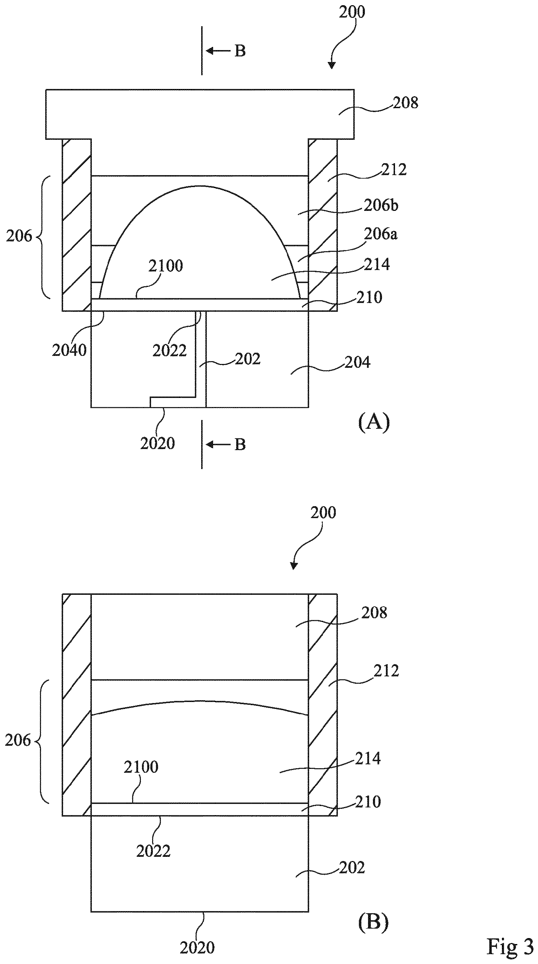

La cellule mémoire décrite en relation avec la figure 2 correspond à un état intermédiaire dans le processus de fabrication de la cellule mémoire. Une étape suivante, correspondant à une étape de "formation" est décrite en relation avec la figure 3.

La figure 3 représente deux vues en coupe simplifiées (A) et (B) d'un mode de réalisation d'une cellule mémoire à changement de phase résultant d'une étape suivante de fabrication.

La vue (B) est une vue en coupe, selon un plan de coupe B-B, de la cellule mémoire 200 représentée en vue (A).

L'étape ayant pour résultat la cellule mémoire 200 de la figure 3 comprend une opération électrique appelée "formation" réalisée après l'étape ayant pour résultat la cellule mémoire de la figure 2. Pendant cette opération, une forte impulsion de courant, typiquement plus grande que les impulsions normalement appliquées pour programmer des cellules mémoire, circule entre l'électrode supérieure 208 et l'électrode inférieure 202 et passe à travers la couche résistive 210 et l'empilement 206.

L'élément résistif 202 chauffe jusqu'à atteindre une température qui est par exemple supérieure à 600 °C, de préférence supérieure à 900 °C, afin de faire fondre une partie des matériaux des couches 206a et 206b. Cette opération forme une partie 214 en un alliage riche en Ge homogène, à partir des parties fondues des couches 206a et 206b. La partie 214 est la zone active de la mémoire à changement de phase. De préférence, l'opération de "formation" est réalisée de telle manière que la partie 214 est dans la phase cristalline à la fin de l'opération.

La partie 214 repose sur la surface supérieure de la couche 210. La partie 214 est ainsi en contact électrique avec l'élément résistif 202, par l'intermédiaire de la couche résistive 210. La partie 214 a la forme d'un dôme, en d'autres termes elle a une section transversale sensiblement en forme de demi-cercle, ou d'une partie circulaire, centrée sur la région de contact entre l'élément résistif 202 et la couche résistive 210. La partie 214 est centrée sur la région de contact entre l'élément résistif 202 et la couche résistive 210 quelle que soit la position de la région de contact. Par conséquent, les problèmes de défauts d'alignement concernant la formation de l'élément résistif 202 sont négligeables, tant que l'élément résistif est en contact avec la couche résistive 210.

Dans l'exemple de la figure 3, la région 214 n'atteint pas la couche 208. En effet, la partie supérieure de la région 214 est séparée de la couche 208 par une partie de la couche 206b. Plus généralement, la partie supérieure de la région 214 peut être séparée de la couche 208 par une partie faite du premier alliage. De préférence, la partie supérieure de la région 214, en d'autres termes la partie de la région 214 la plus proche de la couche 208, n'est pas séparée de la couche 208 par une couche de germanium. En variante, la région 214 peut atteindre la couche 208.

La partie 214 est en un deuxième alliage constitué de germanium, d'antimoine et de tellure, la concentration en germanium du deuxième alliage étant supérieure à celle du premier alliage. Le deuxième alliage est, comme le premier alliage, un matériau à changement de phase, comme ce qui a été décrit précédemment. Les proportions des composants du deuxième alliage par exemple ne sont pas stœchiométriques. La proportion de germanium dans le deuxième alliage est par exemple comprise entre 1,5 fois et 3,5 fois la proportion de germanium dans le premier alliage.

La quantité de germanium dans le deuxième alliage dépend de la quantité de germanium dans les parties chauffées, c'est-à-dire du nombre et de l'épaisseur des couches de germanium 206a, par rapport à la quantité du premier alliage.

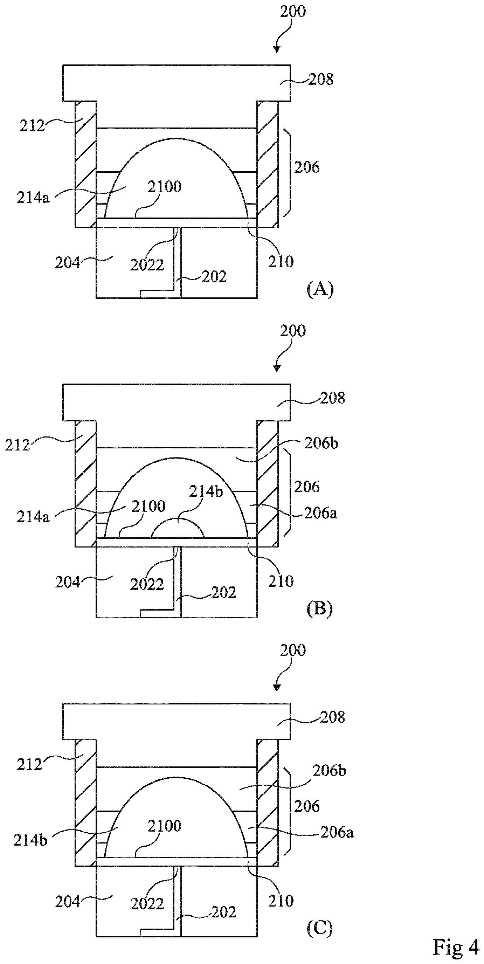

Les données écrites, ou programmés, dans la cellule mémoire sont déterminées par la phase amorphe ou cristalline d'au moins une portion de la partie 214. Un exemple du procédé de programmation va être décrit en relation avec la figure 4.

En raison de la présence de la région isolante 212, la cellule mémoire 200 est appelée "cellule complètement confinée". Dans une matrice mémoire à changement de phase (non représentée), la région isolante 212 se comporte en effet comme une isolation galvanique mais aussi comme une barrière thermique séparant des cellules adjacentes, évitant ainsi des interférences entre cellules. Le phénomène de diaphonie entre cellules mémoire adjacentes, qui a déjà été décrit en référence avec la figure 1, ne peut théoriquement pas se produire dans une cellule mémoire complètement confinée comme la cellule mémoire 200 représentée dans les figures 2 et 3.

La figure 4 représente trois vues en coupe simplifiées (A), (B) et (C), de diverses étapes d'un procédé d'écriture dans une cellule mémoire à changement de phase comme la cellule mémoire décrite en relation avec la figure 3.

La vue (A) représente une cellule PCM similaire à la cellule mémoire 200 susmentionnée, dont la région 214 présente une phase/structure entièrement cristalline. En d'autres termes, la région 214 est, dans la vue (A), entièrement constituée d'une phase/région cristalline 214a. C'est le cas, par exemple avant le début des opérations d'écriture dans la cellule mémoire 200.

Pour écrire dans la cellule mémoire 200, une tension est appliquée entre l'électrode supérieure 208 (couche conductrice) et l'électrode inférieure 202 (élément chauffant). Cette tension donne naissance à un courant électrique s'écoulant à travers la région 214, qui est initialement entièrement constituée de la phase cristalline 214a, et, si la région 214 n'atteint pas l'électrode supérieure 208, à travers une partie de la couche 206b située entre la région 214 et l'électrode 208. La cellule mémoire 200 est ainsi chauffée, par l'élément chauffant 202, jusqu'à une température suffisante pour rendre amorphe au moins une partie de la région cristalline 214.

Dans la vue (B), le chauffage par effet Joule dû au courant électrique s'écoulant à travers la cellule mémoire 200 provoque un changement de phase d'une partie de la région 214, formant ainsi une région amorphe 214b au-dessus de la surface supérieure 2100 de la couche résistive 210. La région amorphe 214b forme un dôme, qui est aligné verticalement avec la surface supérieure 2022 de la partie verticale de l'élément chauffant 202, qui est centrée par rapport à la cellule mémoire 200.

Le deuxième alliage de la région amorphe 214b située directement au-dessus de l'élément chauffant 202 a changé/commuté de phase, en raison du chauffage, d'une phase cristalline à un état amorphe. La région amorphe 214b recouvre seulement partiellement, dans la vue (B), la surface supérieure 2100 de la couche résistive 210 (c'est-à-dire la surface de la couche résistive 210 qui est en contact avec la région 214). Dans la vue (B), la région 214 est par conséquent constituée à la fois de la région amorphe 214b, où le changement de phase a eu lieu lors du chauffage, et de la phase cristalline 214a, dans laquelle le changement de phase n'est pas encore survenu.

Le dôme de la région 214a et le dôme de la région 214b sont tous les deux centrés sur le contact entre la surface supérieure 2022 de la partie verticale de l'élément chauffant 202 et la couche résistive 210. Les deux dômes sont par conséquent automatiquement alignés. Si l'élément chauffant 202 est mal aligné en raison de défauts dans le processus de fabrication, en d'autres termes si l'élément chauffant 202 n'est pas centré, les deux dômes sont encore alignés, puisque leur position dépend de la position de l'élément résistif. Le comportement de la cellule mémoire n'est par conséquent pas impacté de manière significative.

Si une cellule mémoire comme la cellule mémoire 200 représentée en figure (B) est sélectionnée pour une lecture est si la tension de polarisation appropriée est appliquée entre l'électrode supérieure 208 et l'électrode inférieure 202, le courant électrique s'écoule à travers la phase cristalline 214a, la partie de la couche résistive 210 recouverte de la phase amorphe et, potentiellement, la partie de la couche 206b située entre la partie supérieure de la région 214 et l'électrode 208. Le courant électrique s'écoule dans deux chemins parallèles (non représentés en figure 2) de manière à contourner la région amorphe 214b. Chacun de ces deux chemins comprend l'une des deux branches de la partie de la couche résistive 210, ces branches s'étendant dans une direction opposée à partir de la surface supérieure 2022 de l'élément chauffant 202, et sont recouverts par la région amorphe 214b.

En raison du fait que les régions 214a et 214b sont centrées sur l'élément chauffant 202, ces deux chemins ont une résistance électrique équivalente. La résistivité et l'épaisseur de la couche résistive 210 sont telles que la résistance de la cellule mémoire 200 dans l'état représenté en vue (B) est supérieure à la résistance de la cellule mémoire 200 dans l'état représenté en vue (A). En outre, puisque la résistance de la couche résistive 210 est stable dans le temps, la cellule dans l'état représenté en vue (B) est presque exempte du problème de dérive de résistance.

On supposera que la tension, appliquée entre l'électrode supérieure 208 et l'électrode inférieure 202, est ensuite augmentée afin d'augmenter l'intensité du courant électrique s'écoulant à travers l'empilement 206. Cela provoque une montée de température à l'intérieur de l'empilement 206, amenant ainsi le changement de phase à se poursuivre dans la phase cristalline 214a. Une partie du deuxième alliage cristallin, contenu dans la phase cristalline 214a, est par conséquent progressivement convertie en deuxième alliage amorphe, ce qui provoque une région amorphe 214b étendue.

En conséquence, l'étendue de la partie de la couche résistive 210 recouverte par la région amorphe 214b s'agrandit aussi et sa résistance augmente, grosso modo proportionnellement à la longueur de la partie de la surface de 2100 qui est recouverte par la région amorphe 214b. Par conséquent, la résistance de la cellule augmente aussi. Cela permet une programmation de cellule multiniveau, avec une précision analogique, et des valeurs de résistance stables dans le temps (pas de dérive).

Comme cela est représenté en figure (C), le fait de devenir amorphe (c'est-à-dire le processus pendant lequel le deuxième alliage cristallin est transformé en un deuxième alliage amorphe) peut conduire à une situation dans laquelle la région 214 présente une structure entièrement amorphe. En effet, le chauffage a entraîné un remplacement total de la région 214a par la région amorphe 214b.

Grâce à la région isolante 212 entourant la cellule mémoire 200, tous les chemins électriquement conducteurs qui sont théoriquement possibles passent à travers l'empilement 206. En considérant le fait que la région amorphe 214b peut être moins conductrice (ou plus résistive) que la région cristalline 214a de jusqu'à plusieurs ordres de grandeur, la région amorphe 214b ne permet pas la création d'un chemin conducteur à travers la région 214. En outre, à l'extérieur de la région 214, l'empilement comprend au moins une couche 206a. La couche 206a a une résistance élevée, et par conséquent une faible conductivité. Puisque la couche 206a s'étend en regard de la totalité de la couche résistive 210 à l'extérieur de la région 214, il n'y a pas de chemin conducteur dans l'empilement 206. Il ne reste sensiblement pas de chemin conducteur entre l'électrode supérieure 208 et l'électrode inférieure 202.

Les deux électrodes 202, 208 sont par conséquent complètement isolées entre elles grâce à la région isolante 212 et aux régions amorphes 214b et 206a.

Sur la base du fait que, comme montré précédemment, la résistance électrique augmente lorsque la région amorphe 214b croit, trois états mémoire de la cellule mémoire 200 sont arbitrairement définis :
un premier état mémoire est défini par le fait qu'il ne comporte aucune région amorphe 214b recouvrant la surface supérieure 2100 de la couche résistive 210, comme représenté en figure (A) ;
un deuxième état mémoire est défini par le fait qu'il comporte une région amorphe 214b recouvrant totalement la surface supérieure 2100 de la couche résistive 210, comme représenté en figure (C) ; et
un état mémoire intermédiaire est défini par le fait qu'il comporte une région amorphe 214b recouvrant seulement partiellement la surface supérieure 2100 de la couche résistive 210, comme cela est représenté en figure (B).

Ainsi on peut avantageusement obtenir avec la cellule mémoire 200 un nombre d'états mémoire supérieur à deux, à savoir trois états mémoire tels que représentés en figure 4. Cela permet une haute densité de stockage d'informations dans des dispositifs mémoire (non représentés) comprenant une pluralité de cellules PCM 200.

Il faut noter que la résistance de la cellule mémoire 200 augmente de manière monotone en augmentant la partie de la région amorphe 214b qui recouvre la surface supérieure 2100 de la couche résistive 210. Comme la résistance de l'état représenté en vue (B) peut par conséquent être modulée de manière analogique en augmentant le courant de programmation, de multiples niveaux logiques, pour une mémoire numérique, et/ou un stockage analogique, peuvent être considérés pour cet état mémoire, entre les deux états mémoire extrêmes représentés respectivement dans les vues (A) et (C).

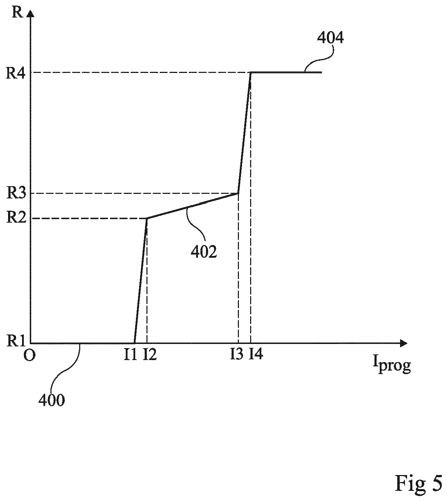

La figure 5 représente la résistance correspondant à plusieurs états de la cellule mémoire à changement de phase. De façon plus précise, la figure 5 représente la résistance (R) entre l'électrode supérieure 208 et l'électrode inférieure 202, en fonction du courant de programmation (I_{prog}) passant à travers la région 214, entre l'électrode supérieure 208 et l'électrode inférieure 202 pendant une étape de programmation.

La courbe de la résistance R comprend trois plateaux 400, 402 et 404. Chaque plateau correspond à au moins une valeur mémorisée par la cellule mémoire à changement de phase.

Le plateau 400 correspond à un courant de programmation compris entre 0 et une valeur de courant I1. La résistance R correspondant à cette plage de courant est sensiblement constante et sensiblement égale à une valeur de résistance R1.

Le plateau 400 correspond à une région 214 entièrement dans la phase cristalline, comme cela est représenté en vue (A) de la figure 4. Pour un courant de programmation inférieur à I1, la température générée par l'élément résistif 202 et la couche résistive 210 n'est pas suffisamment élevée pour changer la phase de la région 214. En d'autres termes, la région 214 ne comprend pas de région amorphe 214b. Par conséquent, la mesure, entre l'électrode supérieure 208 et l'électrode inférieure 202 d'une résistance sensiblement égale à R1 signifie que la cellule mémoire est dans le premier état mémoire.

Le plateau 402 correspond à un courant de programmation compris entre une valeur I2 et une valeur I3. La résistance R correspondant à cette plage de courant augmente de manière monotone d'une valeur R2 jusqu'à une valeur R3.

Le plateau 402 correspond à une région 214 partiellement dans une phase cristalline et partiellement dans une phase amorphe, comme cela est représenté en vue (B) de la figure 4. Pour un courant de programmation compris entre I2 et I3, la température générée par l'élément résistif 202 et la couche résistive 210 est suffisamment élevée pour changer la phase d'une partie de la région 214. En d'autres termes, la région 214 comprend la région amorphe 214b. Par conséquent, la mesure, entre l'électrode supérieure 208 et électrode inférieure 202 d'une résistance comprise entre R2 et R3 signifie que la cellule mémoire est dans le deuxième état mémoire.

Comme cela a été expliqué précédemment, le deuxième état mémoire correspond soit à une seule valeur mémorisée, différente de la valeur mémorisée du premier état mémoire, soit à de multiples niveaux logiques obtenus en modulant de manière analogique la résistance entre les valeurs R2 et R3.

Le plateau 404 correspond à un courant de programmation supérieur à une valeur de courant I4. La résistance R correspondant à cette plage de courant est sensiblement constante et sensiblement égale à une valeur de résistance R4.

Le plateau 404 correspond à une région 214 entièrement dans la phase amorphe, comme cela est représenté en vue (C) de la figure 4. Pour un courant de programmation supérieur à I4, la température générée par l'élément résistif 202 et la couche résistive 210 est suffisamment élevée pour changer la phase de la totalité de la région 214. En d'autres termes, la région 214 ne comprend pas de région cristalline 214a. Par conséquent, la mesure, entre l'électrode supérieure 208 et l'électrode inférieure 202 d'une résistance sensiblement égale à R4 signifie que la cellule mémoire est dans le troisième état mémoire.

Les valeurs de résistance entre R1 et R2 et entre R3 et R4, correspondant respectivement à un courant de programmation entre I1 et I2 et entre I3 et I4, ne correspondent pas à un état mémoire. En d'autres termes, si la résistance R entre l'électrode supérieure 208 et l'électrode inférieure 202 est comprise entre R1 et R2 ou entre R3 et R4, il n'y a pas de valeur mémorisée dans la cellule mémoire. Ces valeurs de courant ne sont pas utilisées pour programmer la cellule mémoire.

La pente du plateau 402 est par exemple inférieure à 5. De manière similaire, les pentes des plateaux 400 et 404 sont par exemple inférieures à 2. La pente de la région correspondant à des valeurs de résistance comprises entre R1 et R2 est par exemple comprise entre 2 et 5 et la pente de la région correspondant à des valeurs de résistance comprises entre R3 et R4 est par exemple supérieure à 5. Cette différence de pente permet de distinguer les diverses régions de la courbe, et par conséquent les divers états mémoire.

La valeur de courant I4 est supérieure à la valeur de courant I3. La valeur de courant I3 est supérieure à la valeur de courant I2. La valeur de courant I2 est supérieure à la valeur de courant I1. En outre, la valeur de résistance R4 est supérieure à la valeur de résistance R3. La valeur de résistance R3 est supérieure à la valeur de résistance R2. La valeur de résistance R2 est supérieure à la valeur de résistance R1.

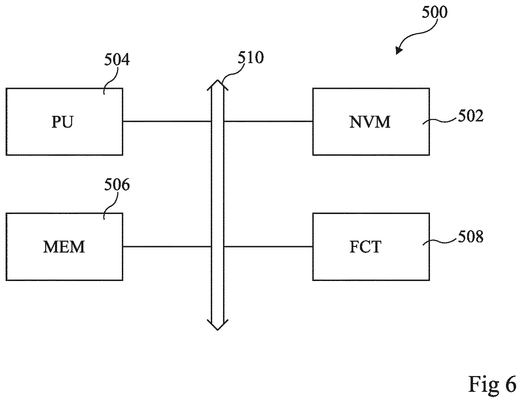

La figure 6 illustre schématiquement un mode de réalisation d'une mémoire 500.

La mémoire 500 comprend :
un ou plusieurs dispositifs mémoire, comme des dispositifs comprenant des cellules mémoire 200 et/ou 300 décrites précédemment, comme cela est représenté en figure 6 par un bloc 502 (NVM) ;
une unité de traitement de données, représentée par un bloc 504 (PU), par exemple, un microprocesseur ;
un ou plusieurs dispositifs mémoire, représentés par un bloc 506 (MEM), et qui peuvent être des dispositifs mémoire différents de ceux du bloc 502 ;
un bloc 508 (FCT) comprenant d'autres fonctions électroniques, par exemple des capteurs, des circuits de contrôle de charge, etc. ; et
un bus de données 510 permettant de transférer des données entre les différents composants.

Le bloc 502 comprend de préférence un circuit pour adresser la matrice de cellules mémoire 200.

Il est possible que les dispositifs mémoire du bloc 506 ne soient pas des dispositifs mémoire à changement de phase, mais des RAM, des mémoires volatiles reprogrammables (EEPROM, flash, etc.).

En variante, le bloc 506 peut être omis. Les dispositifs mémoire de la mémoire 500 sont alors uniquement des dispositifs mémoire comme des dispositifs mémoire comprenant des cellules mémoire 200. La mémoire est alors entièrement une mémoire non volatile.

Un avantage des modes de réalisation décrits ici est que la valeur mémorisée par la cellule mémoire est l'une d'au moins trois valeurs différentes.

Un autre avantage des modes de réalisation décrits ici est que la cellule mémoire comprend un état dans lequel la cellule mémoire peut prendre de multiples niveaux logiques obtenus en modulant de manière analogique la résistance entre les électrodes supérieure et inférieure.

Divers modes de réalisation et variantes ont été décrits. La personne du métier comprendra que certaines caractéristiques de ces divers modes de réalisation pourraient être combinées, et d'autres variantes apparaitront à la personne du métier.

Enfin, la mise en œuvre pratique des modes de réalisation et variantes décrits est à la portée de la personne du métier à partir des indications fonctionnelles données ci-dessus. L'invention est définie par les revendications.

## Revendications

1. Cellule mémoire à changement de phase (200), comprenant :
un élément chauffant (202) ;
un empilement (206) d'au moins une couche de germanium ou
d'une couche de germanium dopé à l'azote (206a) et d'au moins une couche (206b) d'un premier alliage constitué de germanium, d'antimoine et de tellure ; et
**caractérisé en ce qu'**une couche résistive (210) est située entre l'élément chauffant (202) et l'empilement (206).

2. Cellule selon la revendication 1, dans laquelle des parois latérales de l'empilement (206) et de la couche résistive (210) sont entourées d'une région isolante (212).

3. Cellule selon la revendication 1 ou 2, dans laquelle la couche résistive (210) s'étend en dessous de la totalité de la couche inférieure de l'empilement (206).

4. Cellule selon l'une quelconque des revendications 1 à 3, dans laquelle la couche résistive (210) est en contact avec l'élément chauffant (202) et la couche inférieure de l'empilement (206).

5. Cellule selon l'une quelconque des revendications 1 à 4, dans laquelle l'empilement (206) comprend une deuxième région (214) en un deuxième alliage constitué de germanium, d'antimoine et de tellure, la deuxième région s'étendant à partir de la couche résistive (210) et à travers la couche de germanium, ou de germanium dopé à l'azote (206a), le deuxième alliage ayant une concentration en germanium supérieure à celle du premier alliage.

6. Cellule selon l'une quelconque des revendications 1 à 5, dans laquelle une couche conductrice (208) repose sur la couche supérieure de l'empilement (206).

7. Cellule selon les revendications 5 et 6, dans laquelle il n'y a aucune partie de la couche de germanium entre la partie supérieure de la région (214) et la couche conductrice (208).

8. Cellule selon la revendication 5 ou 7, dans laquelle :
un premier état mémoire est défini par le fait que la région (214) est entièrement dans un état cristallin (214a) ;
un deuxième état mémoire est défini par le fait qu'il comporte une région amorphe (214b) recouvrant totalement une surface supérieure (2100) de la couche résistive (210) ; et
au moins un état mémoire intermédiaire est défini par le fait que la région amorphe (214b) recouvre partiellement la surface supérieure (2100) de la couche résistive (210).

9. Procédé de fabrication de la cellule de l'une quelconque des revendications 1 à 8, comprenant une étape dans laquelle une partie de l'empilement (206) est chauffée jusqu'à une température suffisante pour que les parties des couches de germanium ou de germanium dopé à l'azote (206a) et du premier alliage (206b) situées dans cette partie forment un deuxième alliage constitué de germanium, d'antimoine et de tellure, le deuxième alliage ayant une concentration en germanium supérieure à celle du premier alliage.

10. Procédé d'écriture dans la cellule de la revendication 5, 7 ou 8, comprenant une étape de chauffage de la deuxième région (214) afin d'atteindre l'un d'au moins trois états mémoire.

11. Procédé selon la revendication 10, dans lequel la deuxième région (214) est chauffée par l'intermédiaire de l'élément chauffant (202) et de la couche résistive (210).

12. Procédé selon la revendication 10 ou 11, dans lequel la résistance électrique de la cellule (200) augmente de façon monotone en augmentant une partie de la région amorphe (214b) qui recouvre la surface supérieure (2100) de la couche résistive (210).

13. Dispositif mémoire (500) comprenant au moins une cellule mémoire (200) de l'une quelconque des revendications 1 à 8.

## Patentansprüche

1. Phasenwechsel-Speicherzelle (200), die Folgendes aufweist:
einen Heizer (202);
einen Stapel (206) aus mindestens einer Germaniumschicht oder einer stickstoffdotierten Germaniumschicht (206a) und mindestens einer Schicht (206b) aus einer ersten Legierung, die aus Germanium, Antimon und Tellur besteht; und **dadurch gekennzeichnet, dass**
eine Widerstandsschicht (210) zwischen dem Heizer (202) und dem Stapel (206) angeordnet ist.

2. Zelle nach Anspruch 1, wobei die Seitenwände des Stapels (206) und der Widerstandsschicht (210) von einem isolierenden Bereich (212) umgeben sind.

3. Zelle nach Anspruch 1 oder 2, wobei sich die Widerstandsschicht (210) unter der gesamten unteren Schicht des Stapels (206) erstreckt.

4. Zelle nach einem der Ansprüche 1 bis 3, wobei die Widerstandsschicht (210) in Kontakt mit dem Heizer (202) und der unteren Schicht des Stapels (206) steht.

5. Zelle nach einem der Ansprüche 1 bis 4, wobei der Stapel (206) einen zweiten Bereich (214) in einer zweiten Legierung aufweist, die aus Germanium, Antimon und Tellur besteht, wobei sich der zweite Bereich von der Widerstandsschicht (210) und durch die Germanium- oder stickstoffdotierte Germaniumschicht (206a) erstreckt, wobei die zweite Legierung eine höhere Germaniumkonzentration aufweist als die erste Legierung.

6. Zelle nach einem der Ansprüche 1 bis 5, wobei eine leitende Schicht (208) auf der obersten Schicht des Stapels (206) aufliegt.

7. Zelle nach einem der Ansprüche 5 und 6, wobei sich kein Teil der Germaniumschicht zwischen der Oberseite des Bereichs (214) und der leitenden Schicht (208) befindet.

8. Zelle nach Anspruch 5 oder 7, wobei:
ein erster Speicherzustand dadurch definiert ist, dass der Bereich (214) vollständig in einem kristallinen Zustand (214a) ist;
ein zweiter Speicherzustand dadurch definiert ist, dass ein amorpher Bereich (214b) eine obere Fläche (2100) der Widerstandsschicht (210) vollständig bedeckt; und
mindestens ein Zwischen-Speicherzustand dadurch definiert ist, dass der amorphe Bereich (214b) die obere Fläche (2100) der Widerstandsschicht (210) teilweise bedeckt.

9. Verfahren zur Herstellung der Zelle nach einem der Ansprüche 1 bis 8, das einen Schritt aufweist, bei dem ein Teil des Stapels (206) auf eine Temperatur erhitzt wird, die ausreicht, damit die Teile der Schichten aus Germanium oder stickstoffdotiertem Germanium (206a) und der ersten Legierung (206b), die sich in diesem Teil befinden, eine zweite Legierung bilden, die aus Germanium, Antimon und Tellur besteht, wobei die zweite Legierung eine höhere Germaniumkonzentration aufweist als die erste Legierung.

10. Verfahren zum Beschreiben der Zelle nach Anspruch 5, 7 oder 8, wobei das Verfahren einen Schritt des Erhitzens des zweiten Bereichs (214) aufweist, um einen von mindestens drei Speicherzuständen zu erreichen.

11. Verfahren nach Anspruch 10, wobei der zweite Bereich (214) über die Heizvorrichtung (202) und die Widerstandsschicht (210) erhitzt wird.

12. Verfahren nach Anspruch 10 oder 11, wobei sich der elektrische Widerstand der Zelle (200) monoton erhöht durch Zunahme eines Teils des amorphen Bereichs (214b), der die obere Oberfläche (2100) der Widerstandsschicht (210) bedeckt.

13. Speichervorrichtung (500) mit mindestens einer Speicherzelle (200) nach einem der Ansprüche 1 bis 8.

## Claims

1. A phase-change memory cell (200), comprising:
a heater (202);
a stack (206) of at least one germanium layer or a nitrogen doped germanium layer (206a) and at least one layer (206b) of a first alloy made up of germanium, of antimony, and of tellurium; and
**characterized in that**
a resistive layer (210) is located between the heater (202) and the stack (206).

2. The cell of claim 1, wherein side walls of said stack (206) and of the resistive layer (210) are surrounded by an insulating region (212).

3. The cell of claim 1 or 2, wherein the resistive layer (210) extends under the entire bottom layer of the stack (206).

4. The cell of any of claims 1 to 3, wherein the resistive layer (210) is in contact with the heater (202) and the bottom layer of the stack (206).

5. The cell of any of claims 1 to 4, wherein the stack (206) comprises a second region (214) in a second alloy made up of germanium, of antimony, and of tellurium, the second region extending from the resistive layer (210) and through the germanium, or nitrogen doped germanium, layer (206a), the second alloy having a higher germanium concentration than the first alloy.

6. The cell of any of claims 1 to 5, wherein a conductive layer (208) rests on the top layer of the stack (206).

7. The cell of claims 5 and 6, wherein there is no portion of the germanium layer between the top of the region (214) and the conductive layer (208).

8. The cell of claim 5 or 7, wherein:
a first memory state is defined by the region (214) being entirely in a crystalline state (214a);
a second memory state is defined by having an amorphous region (214b) totally covering a top surface (2100) of said resistive layer (210); and
at least one intermediate memory state is defined by having said amorphous region (214b) partially covering said top surface (2100) of said resistive layer (210).

9. A method of manufacturing the cell of any of claims 1 to 8, comprising a step where a portion of the stack (206) is heated up to a temperature sufficient for the portions of layers of germanium or nitrogen doped germanium (206a) and of the first alloy (206b) located in this portion to form a second alloy made up of germanium, of antimony, and of tellurium, the second alloy having a higher germanium concentration than the first alloy.

10. A method of writing to the cell of claim 5, 7 or 8, comprising a step of heating the second region (214) in order to reach one of at least three memory states.

11. The method of claim 10, wherein the second region (214) is heated via the heater (202) and the resistive layer (210).

12. The method of claim 10 or 11, wherein the electrical resistance of said cell (200) increases monotonically by increasing a part of the amorphous region (214b) that covers the top surface (2100) of said resistive layer (210).

13. A memory device (500) comprising at least one memory cell (200) of any of claims 1 to 8.
